# EUROPEAN PATENT APPLICATION

(11) **EP 3 882 326 A1**
(43) Date of publication of application: **22.09.2021**
(21) Application number: 19885088.5
(22) Date of filing: 14.11.2019
(51) Int. Cl.: C09J 183/04, B32B 27/00, C09J 5/00, C09J 11/08, C09J 183/05

(54) **ADHESIVE COMPOSITION FOR INFRARED PEELING, LAMINATE, METHOD FOR PRODUCING LAMINATE, AND PEELING METHOD**

(30) Priority: 16.11.2018 JP 2018215863
(71) Applicant: Nissan Chemical Corporation, Tokyo 103-6119 (JP)
(72) Inventor: SAWADA, Kazuhiro, Toyama-shi, Toyama 939-2792 (JP); MORIYA, Shunsuke, Toyama-shi, Toyama 939-2792 (JP); SHINJO, Tetsuya, Toyama-shi, Toyama 939-2792 (JP); FUKUDA, Takuya, Toyama-shi, Toyama 939-2792 (JP)
(74) Representative: Hoffmann Eitle
(86) International application number: PCT/JP2019/044642
(87) International publication number: WO 2020/100966

(57) **Abstract**

An adhesive composition for use in debonding with infrared radiation, which composition can achieve debonding through irradiation with an infrared ray, the composition including a component (A) which is cured through hydrosilylation and a component (B) which is at least one species selected from the group consisting of a component containing an epoxy-modified polyorganosiloxane, a component containing a methyl group-containing polyorganosiloxane, and a component containing a phenyl group-containing polyorganosiloxane.

## Description

### Technical Field

The present invention relates to an adhesive composition for use in debonding with infrared radiation, the composition serving as a temporary adhesive for fixing a semiconductor wafer or a functional member such as a wiring substrate for mounting parts onto a support. The invention also relates to a laminate employing the adhesive composition, to a method for producing the laminate (hereinafter may be referred to as a "laminate production method"), and to a method for debonding the laminate (hereinafter may be referred to as a "laminate debonding method").

### Background Art

Conventionally, electronic elements and wires are 2-dimensionally (within a plane) integrated on a semiconductor wafer. In a trend toward further integration, demand has arisen for a semiconductor integration technique which achieves 3-dimensional integration (i.e., stacking) in addition to 2-dimensional integration. In the technique of 3-dimensional integration, a number of layers are stacked by the mediation of through silicon vias (TSVs). In integration of multiple layers, each component wafer to be stacked is thinned by polishing a surface opposite the circuit-furnished surface (i.e., a back surface), and the thus-thinned semiconductor wafers are stacked.

Before thinning, the semiconductor wafer (may also be called simply "wafer") is fixed to a support for facilitating polishing by means of a polishing machine. Since the fixation must be removed after polishing, the fixation is called temporary bonding.

When the temporary bonding is removed by excessive force, in some cases a thinned semiconductor wafer may be broken or deformed. In order to prevent such a phenomenon, the temporarily bonded support must be detached in a gentle manner. However, from another aspect, it is not preferred that the temporarily bonded support be removed or slid by a stress applied during polishing of the back surface of the semiconductor wafer. Therefore, temporary bonding must withstand the stress during polishing and must be easily removed after polishing.

For example, one required performance includes having high stress (i.e., strong adhesion) within the plane during polishing and low stress (i.e., weak adhesion) toward the thickness direction during detaching.

Under such circumstances, temporary bonding must be performed with high stress (i.e., strong adhesion) within the plane during polishing and low stress (i.e., weak adhesion) toward the thickness direction during detaching. There have been reported several methods in relation to temporary bonding, including a method including forming a release layer through plasma polymerization of dimethylsiloxane and mechanically removing the release layer from an adhesive layer after polishing (see, for example, Patent Documents 1 and 2), and a method including fixing a semiconductor wafer to a support substrate by use of an adhesive composition, polishing the back surface of the semiconductor wafer, and removing the adhesive with an etchant (see, for example, Patent Document 3). As an embodiment of fixing a semiconductor wafer to a support by the mediation of an adhesive layer or the like, there has been reported a wafer processed body having a polymer layer formed by polymerizing an alkenyl group-containing organopolysiloxane and a hydrosilyl group-containing organopolysiloxane in the presence of a platinum catalyst in combination with a polymer layer formed of a thermosetting polysiloxane (see, for example, Patent Documents 4 to 6). Further, a composition containing a long chain α-acetylene alcohol and a curable silicone is reported as a hydrosilylation inhibitor (see, for example, Patent Document 7). However, recently, under rapid development in the semiconductor field, there is continuously strong demand for renewal and improvement of techniques, particularly those in relation to temporary bonding.

In addition to thinning wafers, the aforementioned temporary bonding is employed in, for example, a mounting process of mounting functional members (e.g., semiconductor elements) onto a functional substrate (e.g., a wiring substrate). In one specific mode, a temporarily bonded support is used for supporting the functional substrate in the first step, and parts are mounted. Then, the support is removed after molding.

### Prior Art Documents

### Patent Documents

Patent Document 1: Japanese Patent Application (kohyo) Publication No. 2012-510715
Patent Document 2: Japanese Patent Application (kohyo) Publication No. 2012-513684
Patent Document 3: Japanese Patent Application Laid-Open (kokai) No. 2013-179135
Patent Document 4: Japanese Patent Application Laid-Open (kokai) No. 2013-232459
Patent Document 5: Japanese Patent Application Laid-Open (kokai) No. 2006-508540
Patent Document 6: Japanese Patent Application Laid-Open (kokai) No. 2009-528688
Patent Document 7: Japanese Patent Application Laid-Open (kokai) No. 1994-329917

### Summary of the Invention

### Problems to be Solved by the Invention

Thus, an object of the present invention is to provide an adhesive composition for use in debonding with infrared radiation, the adhesive composition having excellent heat resistance during joining to a support (i.e., curing), processing of the back surface of a wafer, and a partmounting process, and achieving temporary bonding so that the support can be easily removed. Another object is to provide a laminate employing the adhesive composition and a laminate production method. Still another object is to provide a method for debonding the laminate.

### Means for Solving the Problems

In a first mode of the present invention, there is provided an adhesive composition for use in debonding with infrared radiation, which composition can achieve debonding through irradiation with an infrared ray (i.e., infrared radiation debonding), characterized in that the composition comprises a component (A) which is cured through hydrosilylation and a component (B) which is at least one species selected from the group consisting of a component containing an epoxy-modified polyorganosiloxane, a component containing a methyl group-containing polyorganosiloxane, and a component containing a phenyl group-containing polyorganosiloxane.

A second mode is directed to a specific embodiment of the adhesive composition for use in debonding with infrared radiation as described in the first mode, wherein the component (A) comprises a polysiloxane (A1) having one or more units selected from the group consisting of a siloxane unit represented by SiO₂ (unit Q), a siloxane unit represented by R¹ R² R³ SiO_{1/2} (unit M), a siloxane unit represented by R⁴R⁵SiO_{2/2} (unit D), and a siloxane unit represented by R⁶SiO_{3/2} (unit T) (wherein each of R¹ to R⁶ is a group or an atom bonded to a silicon atom and represents an alkyl group, an alkenyl group, or a hydrogen atom) and a platinum group metal catalyst (A2); and
the polysiloxane (A1) comprises
a polyorganosiloxane (a1) having one or more units selected from the group consisting of a siloxane unit represented by SiO₂ (unit Q'), a siloxane unit represented by R^{1'} R^{2'} R^{3'} SiO_{1/2} (unit M'), a siloxane unit represented by R^{4'} R^{5'} SiO_{2/2} (unit D'), and a siloxane unit represented by R^{6'} SiO_{3/2} (unit T'), and at least one unit selected from the group consisting of unit M', unit D', and unit T' (wherein each of R^{1'} to R^{6'} is a group bonded to a silicon atom and represents an alkyl group or an alkenyl group, and at least one of R^{1'} to R^{6'} is an alkenyl group), and
a polyorganosiloxane (a2) having one or more units selected from the group consisting of a siloxane unit represented by SiO₂ (unit Q'') a siloxane unit represented by R^{1''} R^{2''} R^{3''} SiO_{1/2} (unit M''), a siloxane unit represented by R^{4''} R^{5''} SiO_{2/2} (unit D''), and a siloxane unit represented by R^{6''} SiO_{3/2} (unit T'') and at least one unit selected from the group consisting of unit M'', unit D'', and unit T'' (wherein each of R^{1''} to R^{6''} is a group or an atom bonded to a silicon atom and represents an alkyl group or a hydrogen atom, and at least one of R^{1''} to R^{6''} is a hydrogen atom).

A third mode is directed to a specific embodiment of the adhesive composition for use in debonding with infrared radiation as described in the first or second mode, wherein the epoxy-modified polyorganosiloxane has an epoxy value of 0.1 to 5.

A fourth mode is directed to a specific embodiment of the adhesive composition for use in debonding with infrared radiation as described in any of the first to third modes, wherein the phenyl group-containing polyorganosiloxane has a phenylmethylsiloxane unit structure or a diphenylsiloxane unit structure (b1), and a dimethylsiloxane unit structure (b2) .

A fifth mode provides a laminate comprising a first substrate formed of a semiconductor-forming substrate, and a second substrate formed of a support substrate which allows passage of infrared laser light, the first substrate being joined to the second substrate by the mediation of an adhesive layer, wherein the adhesive layer is a cured film obtained from an adhesive composition for use in debonding with infrared radiation as recited in any of the first to fourth modes.

A sixth mode provides a method for producing a laminate as recited in the fifth mode, the method comprising
a first step of applying the adhesive composition for use in debonding with infrared radiation onto a surface of the first substrate or the second substrate, to thereby form an adhesive coating layer; and
a second step of bonding the first substrate to the second substrate by the mediation of the adhesive coating layer; applying a load to the first substrate and the second substrate in a thickness direction, to thereby closely bind the first substrate, the adhesive coating layer, and the second substrate layer, while at least one of a heat treatment and a reduced pressure treatment is performed; and then performing a post-heat treatment.

A seventh mode provides a debonding method comprising irradiating the laminate produced through the laminate production method as recited in the sixth mode with the infrared laser light from the second substrate side, to thereby debond the second substrate.

An eighth mode is directed to a specific embodiment of debonding method as described in the seventh mode, wherein the infrared laser light has a wavelength of 1 to 20 µm.

A ninth mode is directed to a specific embodiment of debonding method as described in the eighth mode, wherein the wavelength is 9.2 to 10.8 µm.

The adhesive composition of the present invention for use in debonding with infrared radiation contains both a component (A) which is cured through hydrosilylation and a component (B) which is at least one species selected from the group consisting of a component containing an epoxy-modified polyorganosiloxane, a component containing a methyl group-containing polyorganosiloxane, and a component containing a phenyl group-containing polyorganosiloxane. Thus, an adhesive layer which can be debonded through irradiation with an infrared ray can be formed. The adhesive composition exhibits excellent spin-coatability to the circuit-furnished surface of a wafer and can provide an adhesive layer which exhibits excellent heat resistance during joining thereof to a circuit-furnished surface of a wafer or to a support or processing of the back surface of a wafer.

An example of the processing of the surface opposite the circuit-furnished surface of a wafer is a thinning of the wafer through polishing. Thereafter, silicon vias (TSVs) and the like may be formed. The thinned wafer is removed from the support, and a plurality of such wafers are stacked to form a wafer laminate, to thereby complete 3-dimensional mounting. Before or after the above process, a backside electrode and the like are formed on the wafer. When thinning of a wafer and the TSV process are performed, a thermal load of 250 to 350°C is applied to the laminate bonded to the support. The laminate produced by use of the adhesive composition for use in debonding with infrared radiation of the present invention has heat resistance to the load.

After completion of backside processing of the wafer (i.e., polishing), the wafer can be easily separated through irradiation with an infrared ray. After separation, the adhesive stuck on the wafer and the support can be easily removed by solvent or a tape.

Also, according to the method for debonding the laminate produced by use of the adhesive composition of the present invention for use in debonding with infrared radiation, debonding can be easily achieved by irradiation with infrared laser light generally employed in laser processing. Thus, debonding can be performed by means of an apparatus customary employed in laser processing, without use of a particularly arranged apparatus.

### Brief Description of the Drawings

[FIG. 1] A schematic view for illustrating the laminate production method of the present invention.
[FIG. 2] A schematic view for illustrating an example of the debonding method of the present invention.

### Modes for Carrying Out the Invention

The adhesive composition of the present invention for use in debonding with infrared radiation is an adhesive for use in bonding the circuit-furnished surface of a wafer to a support in a peelable manner and processing the back side of the wafer. The adhesive composition contains a component (A) which is cured through hydrosilylation and a component (B) which is at least one species selected from the group consisting of a component containing an epoxy-modified polyorganosiloxane, a component containing a methyl group-containing polyorganosiloxane, and a component containing a phenyl group-containing polyorganosiloxane.

The adhesive composition of the present invention for use in debonding with infrared radiation provides an adhesive layer which can be separated through irradiation with an infrared ray. Therefore, the adhesive layer can be debonded off without applying an excessive peeling load to the support or the wafer, which is advantageous.

According to the present invention, a wafer is temporarily bonded to a support by the mediation of adhesive composition of the present invention for use in debonding with infrared radiation. By processing (e.g., polishing) the surface opposite the circuit-furnished surface (i.e., the back surface) of the wafer, the wafer can be thinned.

Also, the laminate of the present invention includes a first substrate formed of a semiconductor-forming substrate, and a second substrate formed of a support substrate which allows passage of infrared laser light, the first substrate being joined to the second substrate by the mediation of an adhesive layer which is formed by use of the adhesive composition for use in debonding with infrared radiation.

The laminate can be debonded off through irradiation with infrared laser light. Therefore, the adhesive layer can be debonded off without applying an excessive load for debonding.

Thus, the second substrate formed must allow passage of an infrared ray which induces debonding. However, if the laminated can be irradiated with an infrared ray from the first substrate side, no infrared transmitting property is required for the second substrate.

As used herein, the expression "can be debonded" or "peelable" refers to a state of lower bonding strength. In other words, it means excellent peelability for ensuring easy debonding. The bonding strength of the adhesive layer obtained by use of the adhesive composition of the present invention for use in debonding with infrared radiation is considerably reduced through irradiation with an infrared ray, as compared with that in the stage before irradiation.

The adhesive layer (i.e., a temporary bonding layer) of the laminate of the present invention is formed from the adhesive composition of the present invention for use in debonding with infrared radiation. The adhesive composition for use in debonding with infrared radiation contains the aforementioned components (A) and (B) and may further contain other components.

In one preferred embodiment of the present invention, the component (A) contains, as a component which is cured through hydrosilylation, a polysiloxane (A1) having one or more units selected from the group consisting of a siloxane unit represented by SiO₂ (unit Q), a siloxane unit represented by R¹ R² R³ SiO_{1/2} (unit M), a siloxane unit represented by R⁴R⁵SiO_{2/2} (unit D), and a siloxane unit represented by R⁶SiO_{3/2} (unit T), and a platinum group metal catalyst (A2); wherein
the polysiloxane (A1) contains
a polyorganosiloxane (a1) having one or more units selected from the group consisting of a siloxane unit represented by SiO₂ (unit Q'), a siloxane unit represented by R^{1'} R^{2'} R^{3'} SiO_{1/2} (unit M'), a siloxane unit represented by R^{4'} R^{5'} SiO_{2/2} (unit D'), and a siloxane unit represented by R^{6'} SiO_{3/2} (unit T'), and at least one unit selected from the group consisting of unit M', unit D', and unit T', and
a polyorganosiloxane (a2) having one or more units selected from the group consisting of a siloxane unit represented by SiO₂ (unit Q'') a siloxane unit represented by R^{1''} R^{2''} R^{3''} SiO_{1/2} (unit M''), a siloxane unit represented by R^{4''} R^{5''} SiO_{2/2} (unit D''), and a siloxane unit represented by R^{6''} SiO_{3/2} (unit T''), and at least one unit selected from the group consisting of unit M'', unit D'', and unit T''.

Each of R¹ to R⁶ is a group or an atom bonded to a silicon atom and represents an alkyl group, an alkenyl group, or a hydrogen atom.

Each of R^{1'} to R^{6'} is a group bonded to a silicon atom and represents an alkyl group or an alkenyl group, and at least one of R^{1'} to R^{6'} is an alkenyl group.

Each of R^{1''} to R^{6''} is a group or an atom bonded to a silicon atom and represents an alkyl group or a hydrogen atom, and at least one of R^{1''} to R^{6''} is a hydrogen atom.

The alkyl group may be linear-chain, branched-chain, or cyclic. No particular limitation is imposed on the number of carbon atoms thereof, and the number of carbon atoms is preferably 40 or less, more preferably 30 or less, still more preferably 20 or less, yet more preferably 10 or less.

Specific examples of the linear-chain or branched chain alkyl group include, but are not limited to, methyl, ethyl, n-propyl, i-propyl, n-butyl, i-butyl, s-butyl, t-butyl, n-pentyl, 1-methyl-n-butyl, 2-methyl-n-butyl, 3-methyl-n-butyl, 1,1-dimethyl-n-propyl, 1,2-dimethyl-n-propyl, 2,2-dimethyl-n-propyl, 1-ethyl-n-propyl, n-hexyl, 1-methyl-n-pentyl, 2-methyl-n-pentyl, 3-methyl-n-pentyl, 4-methyl-n-pentyl, 1,1-dimethyl-n-butyl, 1,2-dimethyl-n-butyl, 1,3-dimethyl-n-butyl, 2,2-dimethyl-n-butyl, 2,3-dimethyl-n-butyl, 3,3-dimethyl-n-butyl, 1-ethyl-n-butyl, 2-ethyl-n-butyl, 1,1,2-trimethyl-n-propyl, 1,2,2-trimethyl-n-propyl, 1-ethyl-1-methyl-n-propyl, and 1-ethyl-2-methyl-n-propyl.

Of these, methyl is preferred.

Specific examples of the cyclic alkyl group include, but are not limited to, cycloalkyl groups such as cyclopropyl, cyclobutyl, 1-methyl-cyclopropyl, 2-methyl-cyclopropyl, cyclopentyl, 1-methyl-cyclobutyl, 2-methyl-cyclobutyl, 3-methyl-cyclobutyl, 1,2-dimethyl-cyclopropyl, 2,3-dimethyl-cyclopropyl, 1-ethyl-cyclopropyl, 2-ethylcyclopropyl, cyclohexyl, 1-methyl-cyclopentyl, 2-methyl-cyclopentyl, 3-methyl-cyclopentyl, 1-ethyl-cyclobutyl, 2-ethyl-cyclobutyl, 3-ethyl-cyclobutyl, 1,2-dimethyl-cyclobutyl, 1,3-dimethyl-cyclobutyl, 2,2-dimethyl-cyclobutyl, 2,3-dimethyl-cyclobutyl, 2,4-dimethyl-cyclobutyl, 3,3-dimethyl-cyclobutyl, 1-n-propyl-cyclopropyl, 2-n-propyl-cyclopropyl, 1-i-propyl-cyclopropyl, 2-i-propyl-cyclopropyl, 1,2,2-trimethyl-cyclopropyl, 1,2,3-trimethyl-cyclopropyl, 2,2,3-trimethyl-cyclopropyl, 1-ethyl-2-methyl-cyclopropyl, 2-ethyl-1-methyl-cyclopropyl, 2-ethyl-2-methyl-cyclopropyl, and 2-ethyl-3-methyl-cyclopropyl; and bicycloalkyl groups such as bicyclobutyl, bicyclopentyl, bicyclohexyl, bicycloheptyl, bicyclooctyl, bicyclononyl, and bicyclodecyl.

The alkenyl group may be linear-chain or branched-chain. No particular limitation is imposed on the number of carbon atoms thereof, and the number of carbon atoms is preferably 40 or less, more preferably 30 or less, still more preferably 20 or less.

Specific examples of the alkenyl group include, but are not limited to, ethenyl, 1-propenyl, 2-propenyl, 1-methyl-1-ethenyl, 1-butenyl, 2-butenyl, 3-butenyl, 2-methyl-1-propenyl, 2-methyl-2-propenyl, 1-ethylethenyl, 1-methyl-1-propenyl, 1-methyl-2-propenyl, 1-pentenyl, 2-pentenyl, 3-pentenyl, 4-pentenyl, 1-n-propylethenyl, 1-methyl-1-butenyl, 1-methyl-2-butenyl, 1-methyl-3-butenyl, 2-ethyl-2-propenyl, 2-methyl-1-butenyl, 2-methyl-2-butenyl, 2-methyl-3-butenyl, 3-methyl-1-butenyl, 3-methyl-2-butenyl, 3-methyl-3-butenyl, 1,1-dimethyl-2-propenyl, 1-i-propylethenyl, 1,2-dimethyl-1-propenyl, 1,2-dimethyl-2-propenyl, 1-cyclopentenyl, 2-cyclopentenyl, 3-cyclopentenyl, 1-hexenyl, 2-hexenyl, 3-hexenyl, 4-hexenyl, 5-hexenyl, 1-methyl-1-pentenyl, 1-methyl-2-pentenyl, 1-methyl-3-pentenyl, 1-methyl-4-pentenyl, 1-n-butylethenyl, 2-methyl-1-pentenyl, 2-methyl-2-pentenyl, 2-methyl-3-pentenyl, 2-methyl-4-pentenyl, 2-n-propyl-2-propenyl, 3-methyl-1-pentenyl, 3-methyl-2-pentenyl, 3-methyl-3-pentenyl, 3-methyl-4-pentenyl, 3-ethyl-3-butenyl, 4-methyl-1-pentenyl, 4-methyl-2-pentenyl, 4-methyl-3-pentenyl, 4-methyl-4-pentenyl, 1,1-dimethyl-2-butenyl, 1,1-dimethyl-3-butenyl, 1,2-dimethyl-1-butenyl, 1,2-dimethyl-2-butenyl, 1,2-dimethyl-3-butenyl, 1-methyl-2-ethyl-2-propenyl, 1-s-butylethenyl, 1,3-dimethyl-1-butenyl, 1,3-dimethyl-2-butenyl, 1,3-dimethyl-3-butenyl, 1-i-butylethenyl, 2,2-dimethyl-3-butenyl, 2,3-dimethyl-1-butenyl, 2,3-dimethyl-2-butenyl, 2,3-dimethyl-3-butenyl, 2-i-propyl-2-propenyl, 3,3-dimethyl-1-butenyl, 1-ethyl-1-butenyl, 1-ethyl-2-butenyl, 1-ethyl-3-butenyl, 1-n-propyl-1-propenyl, 1-n-propyl-2-propenyl, 2-ethyl-1-butenyl, 2-ethyl-2-butenyl, 2-ethyl-3-butenyl, 1,1,2-trimethyl-2-propenyl, 1-t-butylethenyl, 1-methyl-1-ethyl-2-propenyl, 1-ethyl-2-methyl-1-propenyl, 1-ethyl-2-methyl-2-propenyl, 1-i-propyl-1-propenyl, 1-i-propyl-2-propenyl, 1-methyl-2-cyclopentenyl, 1-methyl-3-cyclopentenyl, 2-methyl-1-cyclopentenyl, 2-methyl-2-cyclopentenyl, 2-methyl-3-cyclopentenyl, 2-methyl-4-cyclopentenyl, 2-methyl-5-cyclopentenyl, 2-methylene-cyclopentyl, 3-methyl-1-cyclopentenyl, 3-methyl-2-cyclopentenyl, 3-methyl-3-cyclopentenyl, 3-methyl-4-cyclopentenyl, 3-methyl-5-cyclopentenyl, 3-methylene-cyclopentyl, 1-cyclohexenyl, 2-cyclohexenyl, and 3-cyclohexenyl.

Of these, ethenyl and 2-propenyl are preferred.

As described above, the polysiloxane (A1) includes the polyorganosiloxane (a1) and the polyorganosiloxane (a2). In curing, the alkenyl group present in the polyorganosiloxane (a1) and the hydrogen atom (Si-H group) present in the polyorganosiloxane (a2) form a cross-linking structure through hydrosilylation in the presence of the platinum group metal catalyst (A2).

The polyorganosiloxane (a1) has one or more units selected from the group consisting of unit Q', unit M', unit D', and unit T', and at least one unit selected from the group consisting of unit M', unit D', and unit T'. Two or more polyorganosiloxanes satisfying the above conditions may be used in combination as the polyorganosiloxane (a1).

Examples of preferred combinations of two or more units selected from the group consisting of unit Q', unit M', unit D', and unit T' include, but are not limited to, (unit Q' and unit M'), (unit D' and unit M'), (unit T' and unit M'), and (unit Q', unit T', and unit M').

In the case where the polyorganosiloxane (a1) includes two or more polyorganosiloxanes, examples of preferred combinations include, but are not limited to, (unit Q' and unit M') + (unit D' and unit M'; (unit T' and unit M') + (unit D' and unit M'); and (unit Q', unit T', and unit M') + (unit T' and unit M').

The polyorganosiloxane (a2) has one or more units selected from the group consisting of unit Q'', unit M'', unit D'', and unit T'', and at least one unit selected from the group consisting of unit M'', unit D'', and unit T''. Two or more polyorganosiloxanes satisfying the above conditions may be used in combination as the polyorganosiloxane (a2).

Examples of preferred combinations of two or more units selected from the group consisting of unit Q'', unit M'', unit D'', and unit T'' include, but are not limited to, (unit M'' and unit D''), (unit Q'' and unit M''), and (unit Q'', unit T'', and unit M'').

The polyorganosiloxane (a1) is formed of siloxane units in which an alkyl group and/or an alkenyl group is bonded to a silicon atom. The alkenyl group content of the entire substituents R^{1'} to R^{6'} is preferably 0.1 mol% to 50.0 mol%, more preferably 0.5 mol% to 30.0 mol%, and the remaining R^{1'} to R^{6'} may be alkyl groups.

The polyorganosiloxane (a2) is formed of siloxane units in which an alkyl group and/or a hydrogen atom is bonded to a silicon atom. The hydrogen atom content of the entire substituents or atoms R^{1''} to R^{6''} is preferably 0.1 mol% to 50.0 mol%, more preferably 10.0 mol% to 40.0 mol%, and the remaining R^{1''} to R^{6''} may be alkyl groups.

The polysiloxane (A1) includes the polyorganosiloxane (a1) and the polyorganosiloxane (a2). In one preferred embodiment of the present invention, the ratio by mole of alkenyl groups present in the polyorganosiloxane (a1) to hydrogen atoms forming Si-H bonds present in the polyorganosiloxane (a2) is 1.0:0.5 to 1.0:0.66.

The weight average molecular weight of each of the polyorganosiloxane (a1) and the polyorganosiloxane (a2) are generally 500 to 1,000,000, preferably 5,000 to 50,000.

In the present invention, weight average molecular weight may be determined by means of, for example, a GPC apparatus (EcoSEC, HLC-8320GPC, product of Tosoh Corporation) and GPC columns (Shodex(registered trademark), KF-803L, KF-802, and KF-801, products of Showa Denko K.K.) at a column temperature of 40°C and a flow rate of 1.0 mL/min by use of tetrahydrofuran as an eluent (extraction solvent) and polystyrene (product of Sigma-Aldrich) as a standard substance.

Notably, as mentioned below, the polyorganosiloxane (a1) and the polyorganosiloxane (a2) included in the component (A) which is cured through hydrosilylation react with each other via hydrosilylation, to thereby form a cured film. Thus, the curing mechanism differs from the mechanism of curing mediated by, for example, silanol groups. Therefore, neither of the siloxanes of the present invention is required to have a silanol group or a functional group forming a silanol group through hydrolysis (e.g., an alkyloxy group) .

In one preferred embodiment of the present invention, the component (A) contains the aforementioned polysiloxane (A1) and the platinum group metal catalyst (A2).

The platinum-based metallic catalyst is used to accelerate hydrosilylation between alkenyl groups of the polyorganosiloxane (a1) and Si-H groups of the polyorganosiloxane (a2).

Specific examples of the platinum-based metallic catalyst include, but are not limited to, platinum catalysts such as platinum black, platinum(II) chloride, chloroplatinic acid, a reaction product of chloroplatinic acid and a monohydric alcohol, a chloroplatinic acid-olefin complex, and platinum bis(acetoacetate).

Examples of the platinum-olefin complex include, but are not limited to, a complex of platinum with divinyltetramethyldisiloxane.

The amount of platinum group metal catalyst (A2) is generally 1.0 to 50.0 ppm, with respect to the total amount of polyorganosiloxane (a1) and polyorganosiloxane (a2).

In order to suppress the progress of hydrosilylation, the component (A) may contain a polymerization inhibitor (A3) .

No particular limitation is imposed on the polymerization inhibitor, so long as it can suppress the progress of hydrosilylation. Specific examples of the polymerization inhibitor include, but are not limited to, alkynylalkyl alcohols such as 1-ethynyl-1-cyclohexanol.

Generally, the amount of polymerization inhibitor with respect to the polyorganosiloxane (a1) and the polyorganosiloxane (a2) is 1000.0 ppm or more from the viewpoint of attaining the effect, and 10000.0 ppm or less from the viewpoint of preventing excessive suppression of hydrosilylation.

The component (B) employed in the present invention contains at least one member selected from the group consisting of a component containing an epoxy-modified polyorganosiloxane, a component containing a methyl group-containing polyorganosiloxane, and a component containing a phenyl group-containing polyorganosiloxane.

Of these, a component containing an epoxy-modified polyorganosiloxane is particularly preferred.

Examples of the epoxy-modified polyorganosiloxane include a siloxane containing a siloxane unit represented by R¹¹R¹²SiO_{2/2} (unit D¹⁰) .

R¹¹ is a group bonded to a silicon atom and represents an alkyl group, and R¹² is a group bonded to a silicon atom and represents an epoxy group or an organic group containing an epoxy group. Specific examples of the alkyl group include those as exemplified above.

The epoxy group in the organic group containing an epoxy group may be an independent epoxy group which does not condense with another ring structure, or may be an epoxy group forming a condensed ring with another ring structure (e.g., a 1,2-epoxycyclohexyl group).

Specific example of the organic group containing an epoxy group include, but are not limited to, 3-glycidoxypropyl and 2-(3,4-epoxycyclohexyl)ethyl.

In the present invention, examples of preferred epoxy-modified polyorganosiloxanes include, but are not limited to, epoxy-modified polydimethylsiloxane.

The epoxy-modified polyorganosiloxane contains the aforementioned siloxane unit (unit D¹⁰), but may also contain the aforementioned unit Q, unit M and/or unit T, in addition to unit D¹⁰.

In one preferred embodiment of the present invention, specific examples of the epoxy-modified polyorganosiloxane include polyorganosiloxane formed only of unit D¹⁰, polyorganosiloxane formed of unit D¹⁰ and unit Q, polyorganosiloxane formed of unit D¹⁰ and unit M, polyorganosiloxane formed of unit D¹⁰ and unit T, polyorganosiloxane formed of unit D¹⁰, unit Q, and unit M, polyorganosiloxane formed of unit D¹⁰, unit M, and unit T, and polyorganosiloxane formed of unit D¹⁰, unit Q, unit M, and unit T.

The epoxy-modified polyorganosiloxane is preferably an epoxy-modified polyorganodimethylsiloxane having an epoxy value of 0.1 to 5. The weight average molecular weight thereof is generally 1,500 to 500,000, but preferably 100,000 or lower, for the purpose of suppression of deposition in the adhesive.

Specific examples of the epoxy-modified polyorganosiloxane include, but are not limited to, CMS-227 (product of Gelest Inc., weight average molecular weight: 27,000) represented by formula (B-1), ECMS-327 (product of Gelest Inc., weight average molecular weight: 28,800) represented by formula (B-2), KF-101 (product of Shin-Etsu Chemical Co., Ltd., weight average molecular weight: 31,800) represented by formula (B-3), KF-1001 (product of Shin-Etsu Chemical Co., Ltd., weight average molecular weight: 55,600) represented by formula (B-4), KF-1005 (product of Shin-Etsu Chemical Co., Ltd., weight average molecular weight: 11,500) represented by formula (B-5), X-22-343 (product of Shin-Etsu Chemical Co., Ltd., weight average molecular weight: 2,400) represented by formula (B-6), BY16-839 (product of Dow Corning, weight average molecular weight: 51,700) represented by formula (B-7), and ECMS-327 (product of Gelest Inc., weight average molecular weight: 28,800) represented by formula (B-8). 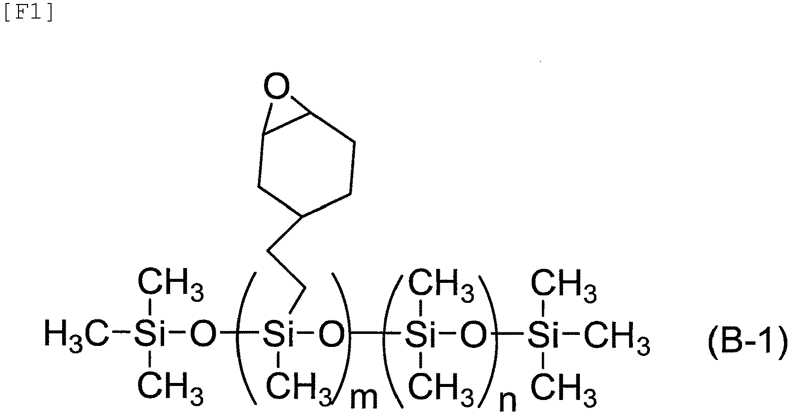 (Each of m and n represents the number of repeating units.) 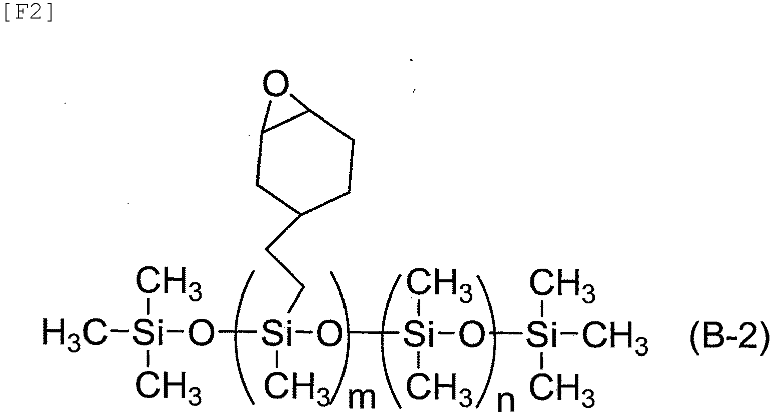 (Each of m and n represents the number of repeating units.) 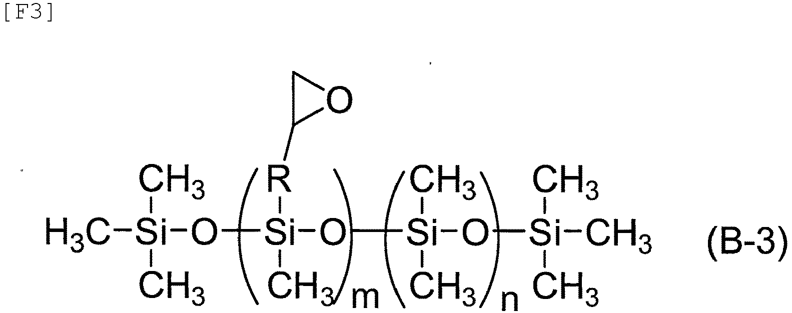 (Each of m and n represents the number of repeating units. R represents a C1 to C10 alkylene group.) 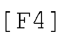 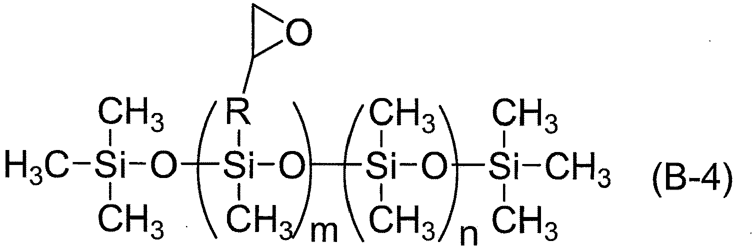 (Each of m and n represents the number of repeating units. R represents a C1 to C10 alkylene group.) 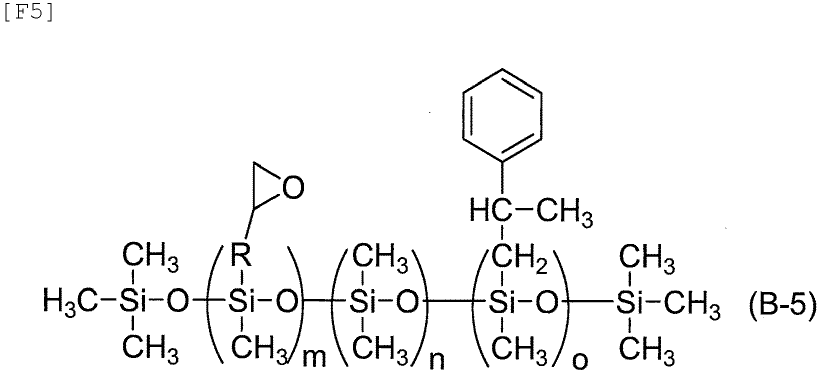 (Each of m, n and o represents the number of repeating units. R represents a C1 to C10 alkylene group.) 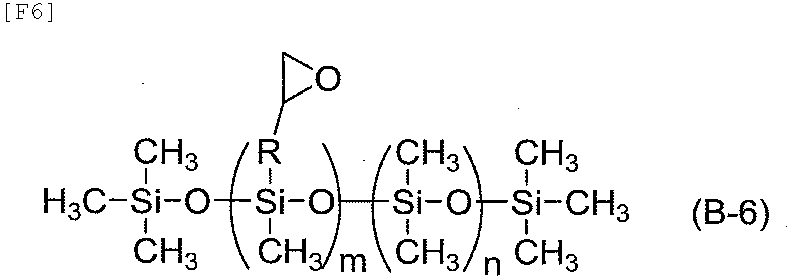 (Each of m and n represents the number of repeating units. R represents a C1 to C10 alkylene group.) 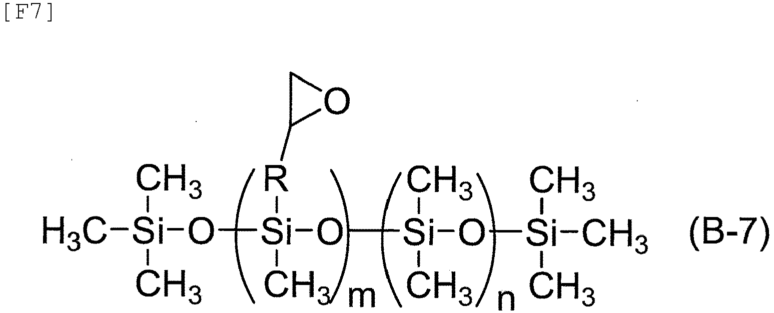 (Each of m and n represents the number of repeating units. R represents a C1 to C10 alkylene group.) 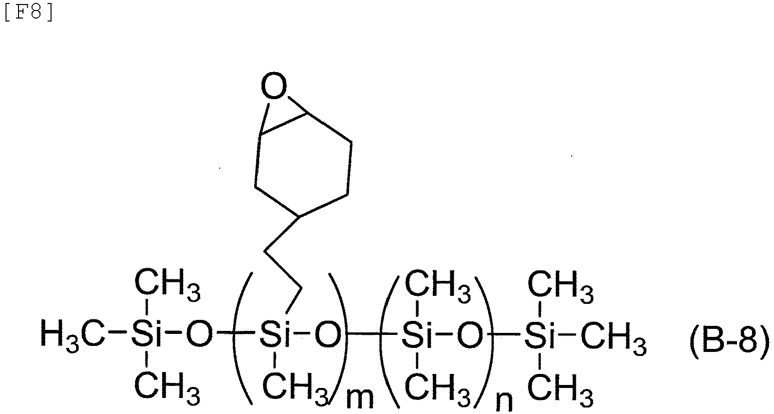 (Each of m and n represents the number of repeating units.)

Examples of the methyl-group-containing polyorganosiloxane include a siloxane containing a siloxane unit represented by R²¹⁰R²²⁰SiO_{2/2} (unit D²⁰⁰). Preferably, the methyl-group-containing polyorganosiloxane contains a siloxane unit represented by R²¹R²¹SiO_{2/2} (unit D²⁰).

Each of R²¹⁰ and R²²⁰ is a group bonded to a silicon atom and represents an alkyl group. At least one of R²¹⁰ and R²²⁰ is a methyl group. Specific examples of the alkyl group include those as exemplified above.

R²¹ is a group bonded to a silicon atom and represents an alkyl group. Specific examples of the alkyl group include those as exemplified above. R²¹ is preferably a methyl group.

In the present invention, examples of preferred methyl-group-containing polyorganosiloxanes include, but are not limited to, polydimethylsiloxane.

The methyl-group-containing polyorganosiloxane contains the aforementioned siloxane unit (unit D²⁰⁰ or unit D²⁰), but may also contain the aforementioned unit Q, unit M and/or unit T, in addition to unit D²⁰⁰ or unit D²⁰.

In one embodiment of the present invention, specific examples of the methyl-group-containing polyorganosiloxane include polyorganosiloxane formed only of unit D²⁰⁰, polyorganosiloxane formed of unit D²⁰⁰ and unit Q, polyorganosiloxane formed of unit D²⁰⁰ and unit M, polyorganosiloxane formed of unit D²⁰⁰ and unit T, polyorganosiloxane formed of unit D²⁰⁰, unit Q, and unit M, polyorganosiloxane formed of unit D²⁰⁰, unit M, and unit T, and polyorganosiloxane formed of unit D²⁰⁰, unit Q, unit M, and unit T.

In one preferred embodiment of the present invention, specific examples of the methyl-group-containing polyorganosiloxane include polyorganosiloxane formed only of unit D²⁰, polyorganosiloxane formed of unit D²⁰ and unit Q, polyorganosiloxane formed of unit D²⁰ and unit M, polyorganosiloxane formed of unit D²⁰ and unit T, polyorganosiloxane formed of unit D²⁰, unit Q, and unit M, polyorganosiloxane formed of unit D²⁰, unit M, and unit T, and polyorganosiloxane formed of unit D²⁰, unit Q, unit M, and unit T.

The viscosity of the methyl-group-containing polyorganosiloxane is generally 1,000 to 2,000,000 mm²/s, preferably 10,000 to 1,000,000 mm²/s. The methyl-group-containing polyorganosiloxane is typically dimethylsilicone oil formed of polydimethylsiloxane. The value of the viscosity is a kinematic viscosity (cSt (=mm²/s)). The kinematic viscosity may be measured by means of a kinematic viscometer. Alternatively, the kinematic viscosity may also calculated by dividing viscosity (mPa·s) by density (g/cm³). In other words, the kinematic viscosity may be determined from a viscosity as measured at 25°C by means of an E-type rotational viscometer and a density. The calculation formula is kinematic viscosity (mm²/s) = viscosity (mPa·s)/density (g/cm³).

Specific examples of the methyl-group-containing polyorganosiloxane include, but are not limited to, WACKER(registered trademark) SILICONE FLUID AK series (products of WACKER) and dimethylsilicone oils (KF-96L, KF-96A, KF-96, KF-96H, KF-69, KF-965, and KF-968) and cyclic dimethylsilicone oil (KF-995) (products of Shin-Etsu Chemical Co., Ltd.).

Examples of the phenyl-group-containing polyorganosiloxane include a siloxane containing a siloxane unit represented by R³¹R³²SiO_{2/2} (unit D³⁰).

R³¹ is a group bonded to a silicon atom and represents a phenyl group or an alkyl group, and R³² is a group bonded to a silicon atom and represents a phenyl group. Specific examples of the alkyl group include those as exemplified above. R³¹ is preferably a methyl group.

The phenyl-group-containing polyorganosiloxane contains the aforementioned siloxane unit (unit D³⁰), but may also contain the aforementioned unit Q, unit M and/or unit T, in addition to unit D³⁰.

In one preferred embodiment of the present invention, specific examples of the phenyl-group-containing polyorganosiloxane include polyorganosiloxane formed only of unit D³⁰, polyorganosiloxane formed of unit D³⁰ and unit Q, polyorganosiloxane formed of unit D³⁰ and unit M, polyorganosiloxane formed of unit D³⁰ and unit T, polyorganosiloxane formed of unit D³⁰, unit Q, and unit M, polyorganosiloxane formed of unit D³⁰, unit M, and unit T, and polyorganosiloxane formed of unit D³⁰, unit Q, unit M, and unit T.

The weight average molecular weight of the phenyl-group-containing polyorganosiloxane is generally 1,500 to 500,000, but preferably 100,000 or lower, for the purpose of suppression of deposition in the adhesive and for other reasons.

Specific examples of the phenyl-group-containing polyorganosiloxane include, but are not limited to, PMM-1043 (product of Gelest Inc., weight average molecular weight: 67,000, viscosity: 30,000 mm²/s) represented by formula (C-1), PMM-1025 (product of Gelest Inc., weight average molecular weight: 25,200, viscosity: 500 mm²/s) represented by formula (C-2), KF50-3000CS (product of Shin-Etsu Chemical Co., Ltd., weight average molecular weight: 39,400, viscosity: 3,000 mm²/s) represented by formula (C-3), TSF431 (product of MOMENTIVE, weight average molecular weight: 1,800, viscosity: 100 mm²/s) represented by formula (C-4), TSF433 (product of MOMENTIVE, weight average molecular weight: 3,000, viscosity: 450 mm²/s) represented by formula (C-5), PDM-0421 (product of Gelest Inc., weight average molecular weight: 6,200, viscosity: 100 mm²/s) represented by formula (C-6), and PDM-0821 (product of Gelest Inc., weight average molecular weight: 8,600, viscosity: 125 mm²/s) represented by formula (C-7). 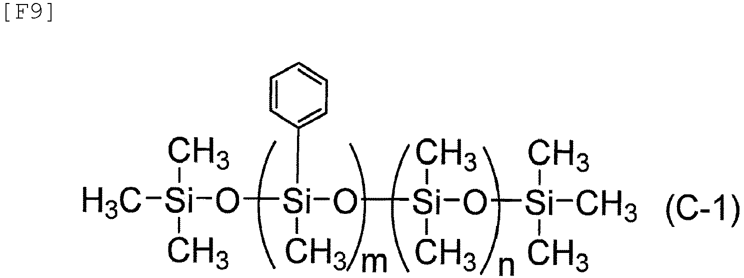 (Each of m and n represents the number of repeating units.) 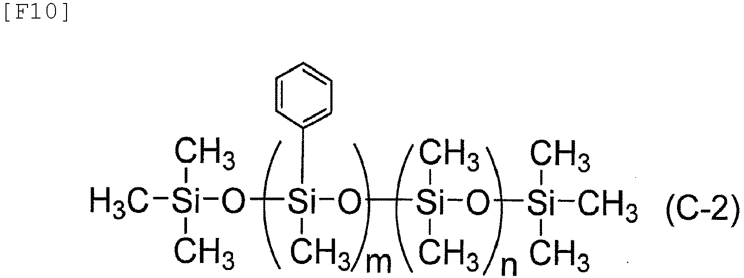 (Each of m and n represents the number of repeating units.) 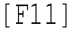 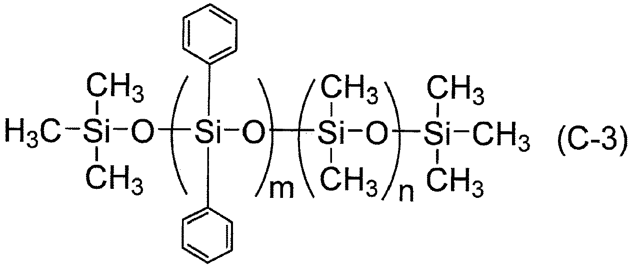 (Each of m and n represents the number of repeating units.) 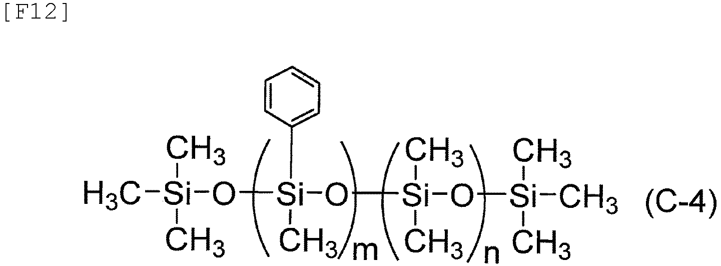 (Each of m and n represents the number of repeating units.) 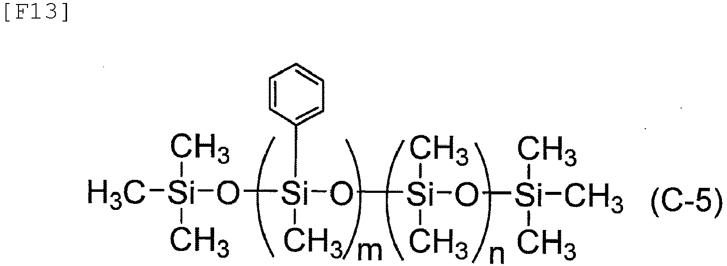 (Each of m and n represents the number of repeating units.) 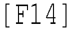 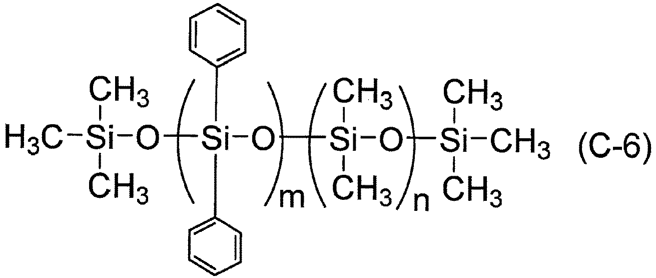 (Each of m and n represents the number of repeating units.) 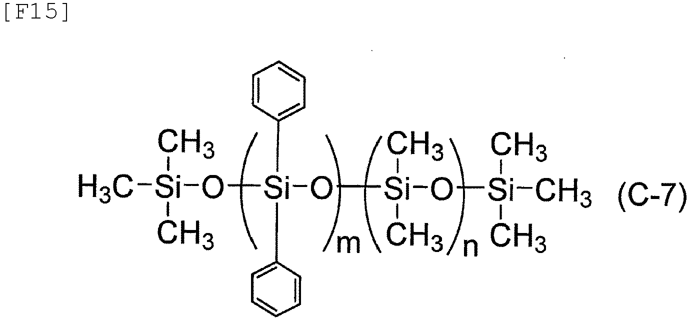 (Each of m and n represents the number of repeating units.)

The adhesive composition of the present invention for use in debonding with infrared radiation contains the components (A) and (B) at any compositional ratio. In consideration of the balance between bonding performance and debonding performance, the compositional ratio (mass%) of component (A) to component (B) is preferably 99.995:0.005 to 30:70, more preferably 99.9:0.1 to 75:25.

For the purpose of adjusting the viscosity or for other reasons, the adhesive composition of the present invention for use in debonding with infrared radiation may contain a solvent. Specific examples of the solvent include, but are not limited to, an aliphatic hydrocarbon, an aromatic hydrocarbon, and a ketone.

More specific examples of the solvent include, but are not limited to, hexane, heptane, octane, nonane, decane, undecane, dodecane, isododecane, menthane, limonene, toluene, xylene, mesitylene, cumene, MIBK (methyl isobutyl ketone), butyl acetate, diisobutyl ketone, 2-octanone, 2-nonanone, and 5-nonanone. These solvents may be used singly or in combination of two or more species.

In the case where the adhesive composition of the present invention for use in debonding with infrared radiation contains a solvent, the solvent content is appropriately adjusted in consideration of a target viscosity of the adhesive, the application method to be employed, the thickness of the formed thin film, etc. The solvent content of the entire composition is about 10 to about 90 mass%.

The adhesive composition of the present invention for use in debonding with infrared radiation may be produced by mixing film-forming components with a solvent. However, when no solvent is used, film-forming components may be mixed together, to thereby prepare the adhesive composition of the present invention for use in debonding with infrared radiation.

No particular limitation is imposed on the sequential order of mixing, so long as the adhesive composition of the present invention for use in debonding with infrared radiation can be easily produced at high reproducibility. One possible example of the production method includes dissolving all film-forming components in a solvent. Another possible example of the production method includes dissolving a part of film-forming components in a solvent, dissolving the other film-forming components in another solvent, and mixing the thus-obtained two solutions. In this case, if required, a part of the solvent or a film-forming component having high dissolvability may be added in a final stage.

So long as the relevant components are not decomposed or denatured in preparation of the adhesive composition, the mixture may be appropriately heated.

In the present invention, in order to remove foreign substances present in the adhesive composition for use in debonding with infrared radiation, the composition may be filtered through a sub-micrometer filter or the like in the course of production of the composition or after mixing all the components.

An embodiment of the laminate production method according to the present invention includes a first step of applying the adhesive composition for use in debonding with infrared radiation onto a surface of a first substrate or a second substrate, to thereby form an adhesive coating layer; and a second step of bonding the first substrate to the second substrate by the mediation of the adhesive coating layer; applying a load to the first substrate and the second substrate in a thickness direction, to thereby closely bind the first substrate, the adhesive coating layer, and the second substrate, while at least one of a heat treatment and a reduced pressure treatment is performed; and then performing a post-heat treatment.

In one example of the present invention, the first substrate is a wafer, and the second substrate is a support. Although the adhesive composition of the present invention for use in debonding with infrared radiation may be applied onto the first substrate and/or the second substrate, the adhesive composition is preferably applied onto the surface of the first substrate.

No particular limitation is imposed on the wafer, and an example of the wafer is a silicon or glass wafer having a diameter of about 300 mm and a thickness of about 770 µm.

No particular limitation is imposed on the support (carrier), so long as the support allows passage of infrared laser light. In this case, the transmittance to laser light is generally 80% or higher, preferably 90% or higher. No particular limitation is imposed on the support, and an example of the support is a silicon wafer having a diameter of about 300 mm and a thickness of about 700 µm.

As used herein, the term "infrared laser light" is laser light employed in the below-mentioned debonding (peeling) step, and an example of the laser light has a wavelength of 1 µm to 20 µm. In one preferred embodiment of the present invention, the wavelength of the infrared laser light is 9.2 to 10.8 µm.

The thickness of the adhesive coating layer is generally 5 to 500 µm. However, the thickness is preferably 10 µm or greater, more preferably 20 µm or greater, still more preferably 30 µm or greater, from the viewpoint of maintaining the film strength, and it is preferably 200 µm or less, more preferably 150 µm or less, still more preferably 120 µm or less, yet more preferably 70 µm or less, from the viewpoint of avoiding variation in uniformity of the film thickness.

No particular limitation is imposed on the application method, and spin coating is generally employed. In an alternative method, a coating film is formed through spin coating or a similar technique, and the sheet-form coating film is attached. The concepts of the application method and the coating film of the invention also encompasses the alternative method and coating film.

The temperature of heating the coated adhesive composition cannot definitely be determined, since the temperature varies depending on the thickness, etc. of the formed adhesive layer. However, the heating temperature is generally 80°C or higher, preferably 150°C or lower, from the viewpoint of prevention of excessive curing. The time of heating is generally 30 seconds or longer, preferably 1 minute or longer, for securing temporary bonding performance. Also, the heating time is generally 5 minutes or shorter, preferably 2 minutes or shorter, from the viewpoint of suppressing deterioration of the adhesive layer and other members.

Heating may be performed by means of a hot plate, an oven, or the like.

The temperature of heating is generally 80°C or higher, preferably 150°C or lower, from the viewpoint of prevention of excessive curing. The time of heating is generally 30 seconds or longer, preferably 1 minute or longer, for securing temporary bonding performance. Also, the heating time is generally 10 minutes or shorter, preferably 5 minutes or shorter, from the viewpoint of suppressing deterioration of the adhesive layer and other members.

In the reduced pressure treatment, the two substrate and the adhesive coating layer therebetween are placed in an atmosphere at 10 Pa to 10,000 Pa. The time of the reduced pressure treatment is generally 1 to 30 minutes.

In one preferred embodiment of the present invention, the two substrates and the adhesive coating layer therebetween are bonded together preferably through a reduced pressure treatment, more preferably through a heating treatment in combination with a reduced pressure treatment.

No particular limitation is imposed on the load which is applied to the first substrate and the second substrate in a thickness direction, so long as the first substrate, the second substrate, and the layer disposed therebetween are not damaged, and these elements are closely adhered. The load is generally 10 to 1,000 N.

The temperature of post-heating is preferably 120°C or higher from the viewpoint of attaining sufficient curing rate, and preferably 260°C or lower from the viewpoint of, for example, preventing deterioration of the substrates and the adhesive. The heating time is generally 1 minute or longer from the viewpoint of achieving suitable joining of a wafer through curing, preferably 5 minutes or longer from the viewpoint of stability in physical properties of the adhesive and for other reasons. Also, the heating time is generally 180 minutes or shorter, preferably 120 minutes or shorter, from the viewpoint of avoiding, for example, an adverse effect on the adhesive layers due to excessive heating. Heating may be performed by means of a hot plate, an oven, or the like.

Notably, a purpose of performing post-heating is to more suitably cure the adhesive composition.

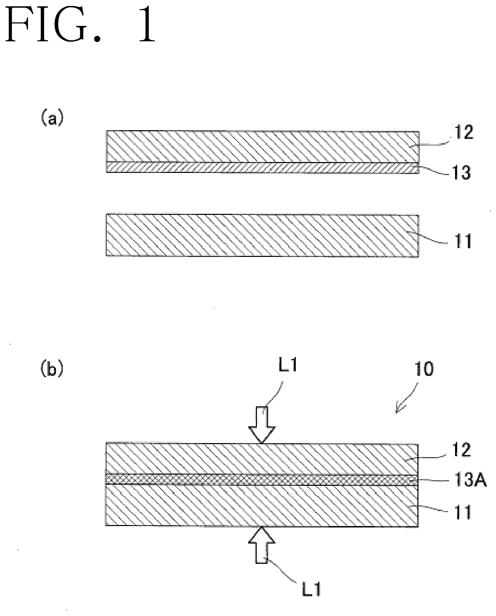

FIG. 1 schematically shows the laminate production method of the present invention. As shown in FIG. 1, a first substrate 11 and a second substrate 12 are provided. In one specific procedure, there is performed a first step of applying the aforementioned adhesive composition for use in debonding with infrared radiation onto a surface of the second substrate 12, to thereby form an adhesive coating layer 13 (FIG. 1(a)). Subsequently, a second step is performed. Specifically, the first substrate 11 is closely adhered to the second substrate 12 by the mediation of the adhesive coating layer 13. A load L1 is applied to the first substrate 11 and the second substrate 12 in a thickness direction, while at least one of the heating treatment and the reduced pressure treatment is performed, whereby the first substrate 11, the second substrate 12, and the layer therebetween are closely bonded together. Then, a post-heating treatment is performed, to thereby finally produce a laminate 10 formed by bonding with an adhesive layer 13A (FIG. 1(b)) .

In the laminate debonding method of the present invention, the laminate is irradiated with the aforementioned infrared laser light from the second substrate side, to thereby remove the second substrate. Generally, the debonding operation is carried out after completion of production of the laminate of the present invention and a specific processing and the like.

As used herein, the term "processing" refers to, for example, a processing of a surface opposite the circuit-furnished surface of a wafer; e.g., a thinning of a wafer by polishing the backside thereof. Thereafter, through silicon vias (TSVs) and the like are formed, and the thinned wafer is removed from the support. A plurality of such wafers are stacked to form a wafer laminate, to thereby complete 3-dimensional mounting. Before or after the above process, a backside electrode and the like are formed on the wafer. When thinning of a wafer and the TSV process are performed, a thermal load of 250 to 350°C is applied to the laminate bonded to the support. The laminate of the present invention including the adhesive layers has heat resistance to the load. Also, the processing is not limited to the aforementioned process and includes, for example, a semiconductor part mounting process in the case where a wafer is temporarily bonded to a support for supporting a substrate on which semiconductor parts are to be mounted.

In one specific embodiment, when the backside surface (a surface opposite the circuit-furnished surface) of a wafer having a diameter of about 300 mm and a thickness of about 770 µm is polished, the thickness of the wafer can be reduced to about 80 µm to about 4 µm.

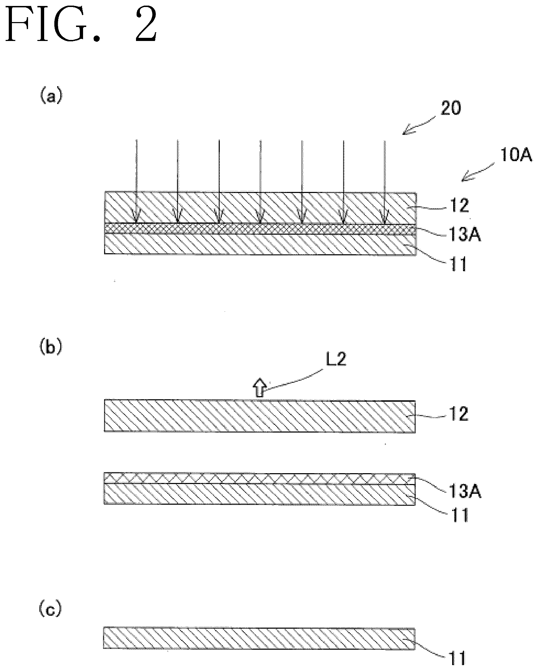

FIG. 2 is a schematic view for illustrating an example of the laminate debonding method of the present invention and a method for producing a processed first substrate from which an adhesive layer has been removed after debonding.

FIG. 2(a) shows a laminate 10A which has received certain processing. The laminate 10A is irradiated with infrared laser light 20 from a second substrate 12 side. When the adhesive layer 13A is irradiated with the infrared laser light 20, the adhesive layer 13A is degraded through thermal decomposition or the like, whereby the adhesion considerably decreases. As a result, the adhesive layer becomes peelable.

Then, as shown in FIG. 2(b), the second substrate 12 is detached from the adhesive layer 13A. In this case, since the adhesive layer 13A has been degraded to have a considerably reduced adhesiveness, the second substrate 12 is easily detached from the first substrate 11 and the adhesive layer 13A by, for example, pulling up with small external force (L2). Finally, the adhesive layer 13A remaining on the first substrate 11 is removed by use of a cleaner formed of, for example, organic solvent, thereby yielding the first substrate 11 which has been processed (e.g., thinned) (FIG. 2 (c)) .

As described above, in the laminate 10 of the present invention, bonding is achieved by the mediation of the adhesive layer formed from the adhesive composition of the present invention for use in debonding with infrared radiation. Thus, the second substrate 12 can be easily peeled off from the first substrate 11 and the adhesive layer 13A through irradiation with infrared laser light.

Notably, the entire area of the adhesive layer is not necessarily irradiated with infrared laser light 20. Even when the adhesive layer 13A has both an infrared laser light 20-irradiated area and an infrared laser light 20-non-irradiated area, it is sufficient that the bonding strength of the entire adhesive layer 13A is satisfactorily reduced. Under such conditions, the second substrate 12 can be easily separated from the laminate 10 by pulling the second substrate 12 through application of small external force thereto. The ratio of the infrared laser light 20-irradiated area to the infrared laser light 20-non-irradiated area and the locational distribution of the two areas vary depending on the type of the adhesive composition for use in debonding with infrared radiation which composition forms the adhesive layer 13A, the thickness of the adhesive layer 13A, the intensity of irradiation infrared laser light 20, and other factors. However, those skilled in the art can set appropriate conditions, without carrying out excessive tests. For example, an infrared laser light-non-irradiated area may be provided adjacent to an infrared laser light-irradiated area with the same width as that of the infrared ray.

Thus, even when only a part of the adhesive layer 13A is irradiated with infrared laser light, the second substrate 12 can be separated. As a result, the time for applying laser light to one laminate can be shortened, whereby the total time for debonding can be shortened.

### Examples

The present invention will next be described in detail by way of example, which should not be construed as limiting the invention thereto. The apparatuses employed in the present invention are as follows.
(1) Agitator: AWATORI RENTAROU (product of Thinky Corporation)
(2) Bonding apparatus: XBS300 (product of Suess Microtec SE) or VJ-300 (product of Ayumi Industry Co., Ltd.)
(3) Dicing machine: Dicing machine SS30 (product of Toyko Seimitsu Co., Ltd.)
(4) Laser process apparatus (Debonding apparatus): Speedy 300 (product of Trotec Laser GmbH [laser wavelength: 10.6 µm, power: 75 W] (conditions: speed: 100 mm/s, 1,000 PPI/Hz)

### [1] Preparation of adhesive

### [Example 1-1]

A base polymer formed of an MQ resin having vinyl groups (Mw: 6,900) (product of WACKER Chemie AG) (10.00 g) serving as polysiloxane (a1), linear-chain polydimethylsiloxane having vinyl groups (viscosity: 1,000 mPa·s) (product of WACKER Chemie AG) (7.01 g) serving as polysiloxane (a1), linear-chain polydimethylsiloxane having Si-H groups (viscosity: 70 mPa·s) (product of WACKER Chemie AG) (1.50 g) serving as polysiloxane (a2), linear-chain polydimethylsiloxane having Si-H groups (viscosity: 40 mPa·s) (product of WACKER Chemie AG) (1.08 g) serving as polysiloxane (a2), 1-ethynyl-1-cyclohexanol (product of WACKER Chemie AG) (0.049 g) serving as a polymerization inhibitor (A3), and X-22-343 (product of Shin-Etsu Chemical Co., Ltd.) (0.197 g) serving as the component (B) containing epoxy-modified polyorganosiloxane were agitated by means of an agitator, to thereby prepare a mixture.

To the thus-obtained mixture, there was added another mixture (0.118 g) prepared by agitating a platinum catalyst (product of WACKER Chemie AG) (1.0 g) serving as a platinum group metal catalyst (A2) and linear-chain polydimethylsiloxane having vinyl groups (viscosity: 1,000 mPa·s) (product of WACKER Chemie AG) (5.0 g) serving as polysiloxane (a1) by means of an agitator for 5 minutes. The resultant mixture was further agitated for 5 minutes, to thereby prepare an adhesive composition containing the components (A) and (B) for use in debonding with infrared radiation.

Notably, X-22-343 has a structure represented by the following formula (B-6). 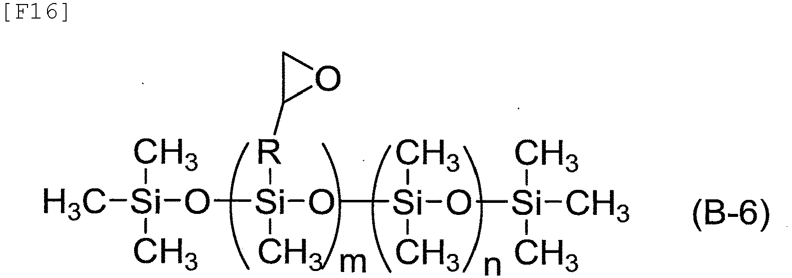 The average molecular weight was 2,400. In the above formula, each of m and n represents the number of repeating units, and R represents a C1 to C10 alkylene group.

### [Example 1-2]

A base polymer formed of an MQ resin having vinyl groups (Mw: 6,900) (product of WACKER Chemie AG) (141.22 g) serving as polysiloxane (a1), linear-chain polydimethylsiloxane having vinyl groups (viscosity: 1,000 mPa·s) (product of WACKER Chemie AG) (35.30 g) serving as polysiloxane (a1), linear-chain polydimethylsiloxane having vinyl groups (viscosity: 200 mPa·s) (product of WACKER Chemie AG) (4.54 g) serving as polysiloxane (a1), linear-chain polydimethylsiloxane having Si-H groups (viscosity: 70 mPa·s) (product of WACKER Chemie AG) (12.11 g) serving as polysiloxane (a2), linear-chain polydimethylsiloxane having Si-H groups (viscosity: 40 mPa·s) (product of WACKER Chemie AG) (7.57 g) serving as polysiloxane (a2), 1-ethynyl-1-cyclohexanol (product of WACKER Chemie AG) (0.504 g) serving as a polymerization inhibitor (A3), 1,1-diphenyl-2-propyn-1-ol (product of Tokyo Chemical Industry Co., Ltd.) (0.504 g) serving as a polymerization inhibitor (A3), X-22-343 (product of Shin-Etsu Chemical Co., Ltd.) (2.02 g) serving as the component (B) containing epoxy-modified polyorganosiloxane, and undecane (product of FUJIFILM Wako Pure Chemical Corporation) (10.69 g) serving as a solvent were agitated by means of an agitator, to thereby prepare a mixture.

To the thus-obtained mixture, there was added another mixture (1.21 g) prepared by agitating a platinum catalyst (product of WACKER Chemie AG) (1.0 g) serving as a platinum group metal catalyst (A2) and linear-chain polydimethylsiloxane having vinyl groups (viscosity: 1,000 mPa·s) (product of WACKER Chemie AG) (5.0 g) serving as polysiloxane (a1) by means of an agitator for 5 minutes. The resultant mixture was further agitated for 5 minutes, to thereby prepare an adhesive composition containing the components (A) and (B) for use in debonding with infrared radiation.

### [Comparative Example 1-1]

A base polymer formed of an MQ resin having vinyl groups (Mw: 6,900) (product of WACKER Chemie AG) (10.00 g) serving as polysiloxane (a1), linear-chain polydimethylsiloxane having vinyl groups (viscosity: 1,000 mPa·s) (product of WACKER Chemie AG) (7.01 g) serving as polysiloxane (a1), linear-chain polydimethylsiloxane having Si-H groups (viscosity: 70 mPa·s) (product of WACKER Chemie AG) (1.50 g) serving as polysiloxane (a2), linear-chain polydimethylsiloxane having Si-H groups (viscosity: 40 mPa·s) (product of WACKER Chemie AG) (1.08 g) serving as polysiloxane (a2), and 1-ethynyl-1-cyclohexanol (product of WACKER Chemie AG) (0.049 g) serving as a polymerization inhibitor (A3) were agitated by means of an agitator, to thereby prepare a mixture.

To the thus-obtained mixture, there was added another mixture (0.118 g) prepared by agitating a platinum catalyst (product of WACKER Chemie AG) (1.0 g) serving as a platinum group metal catalyst (A2) and linear-chain polydimethylsiloxane having vinyl groups (viscosity: 1,000 mPa·s) (product of WACKER Chemie AG) (5.0 g) serving as polysiloxane (a1) by means of an agitator for 5 minutes. The resultant mixture was further agitated for 5 minutes, to thereby prepare a comparative adhesive composition containing the component (A).

### [3] Production of laminate and debonding test

### [Example 2-1]

The adhesive composition for use in debonding with infrared radiation produced in Example 1-1 was applied onto a square-shape glass wafer (300 mm × 300 mm) through spin coating to a final film thickness of about 40 µm, and the wafer was heated at 120°C for 1 minute, to thereby form an adhesive coating layer on the glass wafer.

Then, the glass wafer having the adhesive coating layer and a square-shape silicon wafer (300 mm × 300 mm) were bonded together by means of a bonding apparatus such that the adhesive coating layer was sandwiched by the two wafers. The bonded product was heated for curing at 200°C for 10 minutes (i.e., a post-heat treatment), to thereby produce a laminate. Bonding was performed at 23°C, and a reduced pressure of 1,000 Pa with a load of 30 N.

The thus-produced laminate was diced by means of a dicing apparatus to square pieces (1 cm × 1 cm), and the diced laminate pieces were used as samples for evaluation.

### [Example 2-2]

The procedure of Example 2-1 was repeated, except that the adhesive composition for use in debonding with infrared radiation produced in Example 1-1 was changed to the adhesive composition for use in debonding with infrared radiation produced in Example 1-2, and that bonding was performed at 50°C, and a reduced pressure of 1,000 Pa with a load of 500 N, to thereby produce a laminate and evaluation samples.

### [Comparative Example 2-1]

The procedure of Example 2-1 was repeated, except that the adhesive composition for use in debonding with infrared radiation produced in Example 1-1 was changed to the comparative adhesive composition produced in Comparative Example 1-1, to thereby produce a laminate and evaluation samples.

Each of the laminates was irradiated with laser light by means of a laser processor to induce debonding. The laminate was irradiated with the laser light from the silicon wafer side, and irradiation was performed over the entire surface of the wafer under scanning. Table 1 shows the power (output) of the laser light and occurrence of debonding.

**[Table 1]**

| | Output (%) | Debonding |
|---|---|---|
| Ex. 2-1 | 40 | yes |
| Ex. 2-2 | 40 | yes |
| Comp. Ex. 2-1 | 70 | difficult |

After irradiation with laser light, debonding occurred in the laminate of the present invention, but debonding hardly occurred in the laminate of Comparative Example.

### Industrial Applicability

According to the laminate produced by use of the adhesive composition for use in debonding with infrared radiation of the present invention, debonding can be easily achieved by irradiation with infrared laser light generally employed in laser processing. Thus, debonding can be performed by means of an apparatus customary employed in laser processing, without use of a particularly arranged apparatus. The laminate can be applied to a variety of uses. Description of Reference Numerals

- 10, 10A: laminate
- 11: first substrate
- 12: second substrate
- 13: adhesive coating layer
- 13A: adhesive layer
- 20: infrared laser light

## Claims

1. An adhesive composition for use in debonding with infrared radiation, which composition can achieve debonding through irradiation with an infrared ray, **characterized in that** the composition comprises
a component (A) which is cured through hydrosilylation and
a component (B) which is at least one species selected from the group consisting of a component containing an epoxy-modified polyorganosiloxane, a component containing a methyl group-containing polyorganosiloxane, and a component containing a phenyl group-containing polyorganosiloxane.

2. An adhesive composition for use in debonding with infrared radiation according to claim 1, wherein the component (A) comprises a polysiloxane (A1) having one or more units selected from the group consisting of a siloxane unit represented by SiO₂ (unit Q), a siloxane unit represented by R¹R²R³SiO_{1/2} (unit M), a siloxane unit represented by R⁴R⁵SiO_{2/2} (unit D), and a siloxane unit represented by R⁶SiO_{3/2} (unit T) (wherein each of R¹ to R⁶ is a group or an atom bonded to a silicon atom and represents an alkyl group, an alkenyl group, or a hydrogen atom) and a platinum group metal catalyst (A2); and
the polysiloxane (A1) comprises
a polyorganosiloxane (a1) having one or more units selected from the group consisting of a siloxane unit represented by SiO₂ (unit Q'), a siloxane unit represented by R^{1'}R^{2'}R^{3'}SiO_{1/2} (unit M'), a siloxane unit represented by R^{4'}R^{5'}SiO_{2/2} (unit D'), and a siloxane unit represented by R^{6'}SiO_{3/2} (unit T'), and at least one unit selected from the group consisting of unit M', unit D', and unit T' (wherein each of R^{1'} to R^{6'} is a group bonded to a silicon atom and represents an alkyl group or an alkenyl group, and at least one of R^{1'} to R^{6'} is an alkenyl group), and
a polyorganosiloxane (a2) having one or more units selected from the group consisting of a siloxane unit represented by SiO₂ (unit Q") a siloxane unit represented by R^{1"}R^{2"}R^{3"}SiO_{1/2} (unit M''), a siloxane unit represented by R^{4"}R^{5"}SiO_{2/2} (unit D''), and a siloxane unit represented by R^{6"}SiO_{3/2} (unit T''), and at least one unit selected from the group consisting of unit M'', unit D'', and unit T'' (wherein each of R^{1''} to R^{6''} is a group or an atom bonded to a silicon atom and represents an alkyl group or a hydrogen atom, and at least one of R^{1''} to R^{6''} is a hydrogen atom).

3. An adhesive composition for use in debonding with infrared radiation according to claim 1 or 2, wherein the epoxy-modified polyorganosiloxane has an epoxy value of 0.1 to 5.

4. An adhesive composition for use in debonding with infrared radiation according to any one of claims 1 to 3, wherein the phenyl group-containing polyorganosiloxane has a phenylmethylsiloxane unit structure or a diphenylsiloxane unit structure (b1), and a dimethylsiloxane unit structure (b2) .

5. A laminate comprising a first substrate formed of a semiconductor-forming substrate, and a second substrate formed of a support substrate which allows passage of infrared laser light, the first substrate being joined to the second substrate by the mediation of an adhesive layer, wherein the adhesive layer is a cured film obtained from an adhesive composition for use in debonding with infrared radiation as recited in any one of claims 1 to 4.

6. A method for producing a laminate as recited in claim 5, the method comprising
a first step of applying the adhesive composition for use in debonding with infrared radiation onto a surface of the first substrate or the second substrate, to thereby form an adhesive coating layer; and
a second step of bonding the first substrate to the second substrate by the mediation of the adhesive coating layer; applying a load to the first substrate and the second substrate in a thickness direction, to thereby closely bind the first substrate, the adhesive coating layer, and the second substrate, while at least one of a heat treatment and a reduced pressure treatment is performed; and then performing a post-heat treatment.

7. A debonding method comprising irradiating the laminate produced through a laminate production method as recited claim 6 with the infrared laser light from the second substrate side, to thereby debond the second substrate.

8. A debonding method according to claim 7, wherein the infrared laser light has a wavelength of 1 to 20 µm.

9. A debonding method according to claim 8, wherein the wavelength is 9.2 to 10.8 µm.
